# EUROPEAN PATENT APPLICATION

(11) **EP 4 842 161 A1**
(43) Date of publication of application: **18.11.2026**
(21) Application number: 25300060.8
(22) Date of filing: 13.05.2025
(51) Int. Cl.: H10D 64/20, H01L 23/48, H01L 23/482, H01L 25/065, H03F 1/22, H10D 64/23, H10D 62/85

(54) **AMPLIFIER DEVICES AND TRANSISTORS WITH GROUND-COUPLED FIELD PLATES**

(71) Applicant: NXP USA, Inc., Austin, TX 78735 (US)
(72) Inventor: Yang, Xin, 5656 AE Eindhoven (NL); Acar, Mustafa, 5656 AE Eindhoven (NL); Giannakidis, Konstantinos, 5656 AE Eindhoven (NL); Praamsma, Louis, 5656 AE Eindhoven (NL); Zhang, Lei, 5656 AE Eindhoven (NL); Kabir, Humayun, 5656 AE Eindhoven (NL); Rueda, Hernan, 5656 AE Eindhoven (NL)
(74) Representative: Schwarzweller, Thomas

(57) **Abstract**

A transistor die (240) includes a semiconductor substrate, one or more gate, source, and drain terminals (260, 270, 280), a transistor (247) within an active area in the semiconductor substrate, and one or more through-substrate vias (269) (TSVs) between the active area and the drain terminal. Each TSV extends between a proximal end at a top surface of the base substrate and a distal end at a bottom surface of the base substrate. The transistor includes multiple transistor fingers, and each transistor finger includes a source region (275), a drain region (285), a channel region (265), a gate (264), a source contact (272), a drain contact (282), and a field plate (266) between the gate and the drain contact. Each field plate is electrically coupled to the proximal end of a TSV. The transistor die may be used in a common-gate configuration in an amplifier (100).

## Description

### TECHNICAL FIELD

Embodiments of the subject matter described herein relate generally to amplifier devices and transistors that include field plates, and more generally to amplifier devices that include transistors having a common-gate configuration.

### BACKGROUND

Cascode amplifier circuit topologies are known to provide several advantages over other amplifier topologies. These advantages may include, for example, relatively high gain, wide bandwidth, and increased input-output isolation. Although a cascode amplifier may be implemented using various types of transistors, when using field effect transistors, a cascode amplifier typically is implemented as a two-stage amplifier that includes a common-source amplification stage (input stage) that drives a common-gate amplification stage (output stage). When using bipolar junction transistors, a cascode amplifier typically is implemented as a two-stage amplifier that includes a common-emitter amplification stage (input stage) that drives a common-base amplification stage (output stage). Either way, each amplification stage includes one or more transistors.

To achieve stable amplifier operation, it is desirable to minimize the transistor feedback capacitance of the output stage of a cascode amplifier. Accordingly, in the context of cascode amplifier development, transistor designers strive to develop new transistor structures with reduced feedback capacitance.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a simplified schematic diagram of a two-stage cascode amplifier implemented with field effect transistors;
FIG. 2 is a top view of an amplifier device that embodies a cascode amplifier with a first transistor configured in a common-emitter arrangement and a second transistor configured in a common-gate arrangement, in accordance with an example embodiment;
FIG. 3 is an enlarged top view of the second transistor die of FIG. 2, in accordance with an example embodiment;
FIG. 4 is a cross-sectional, side view of the transistor die of FIG. 3 along line 4-4, in accordance with an example embodiment;
FIG. 5 is a cross-sectional, side view of the transistor die of FIG. 3 along line 5-5, in accordance with an example embodiment;
FIG. 6 is a cross-sectional, side view of the transistor die of FIG. 3 along line 6-6, in accordance with an example embodiment;
FIG. 7 is a cross-sectional, side view of the transistor die of FIG. 3 along line 7-7, in accordance with an example embodiment;
FIG. 8 is a cross-sectional, side view of the transistor die of FIG. 3 along line 8-8, in accordance with an example embodiment; and
FIG. 9 is a cross-sectional, side view of the transistor die of FIG. 3 along line 9-9, in accordance with an example embodiment.

### DETAILED DESCRIPTION

As discussed above, a cascode amplifier may include an input stage with a first transistor configured in a common-emitter or common-source arrangement and an output stage with a second transistor configured in a common-gate arrangement. Various embodiments of the inventive subject matter include transistors that are particularly suitable for use in the output stage of a cascode amplifier, although the transistor embodiments could be used in other types of amplifiers, as well. For example, but not by way of limitation, along with being suitable for use in a cascode amplifier, the transistor embodiments discussed herein also could be used in standalone (e.g., single-stage) amplifiers (e.g., common-gate or common-base standalone amplifiers), single-ended amplifiers, and differential amplifiers.

More specifically, transistor embodiments described herein may be characterized by a relatively low feedback capacitance (e.g., drain-source capacitance in the output stage common-gate arrangement) during operation, in comparison with other conventional transistors. This is achieved, in one or more embodiments, by including a field plate between the transistor gate and the transistor drain contact, and by electrically coupling the field plate to a ground reference node of the transistor. During operation, the field plate may function as a grounded electromagnetic shield between the transistor source and drain. Utilizing the inventive features of the various embodiments may result in a substantial reduction in the drain-source capacitance of a transistor, making such transistor embodiments well suited for use in a common-gate configuration in a cascode amplifier. An embodiment of a cascode amplifier that includes such a transistor may be characterized by better stability, when compared with conventional cascode amplifiers.

As used herein, the term "transistor" means a field effect transistor (FET), a bipolar junction transistor (BJT), or another type of transistor. For example, a "FET" may be a metal-oxide-semiconductor FET (MOSFET), a laterally-diffused MOSFET (LDMOS FET), an enhancement-mode or depletion-mode high electron mobility transistor (HEMT), or another type of FET. A BJT may be a heterojunction BJT (HBT) or another type of BJT. The description below refers to a transistor as including a gate, a source, and a drain or including a base, emitter, and collector. Although the below description may use terminology commonly used in conjunction with FET and BJT devices, the various embodiments are not limited to implementations that utilize FET and BJT devices, and instead are meant to apply also to implementations that utilize other types of transistors.

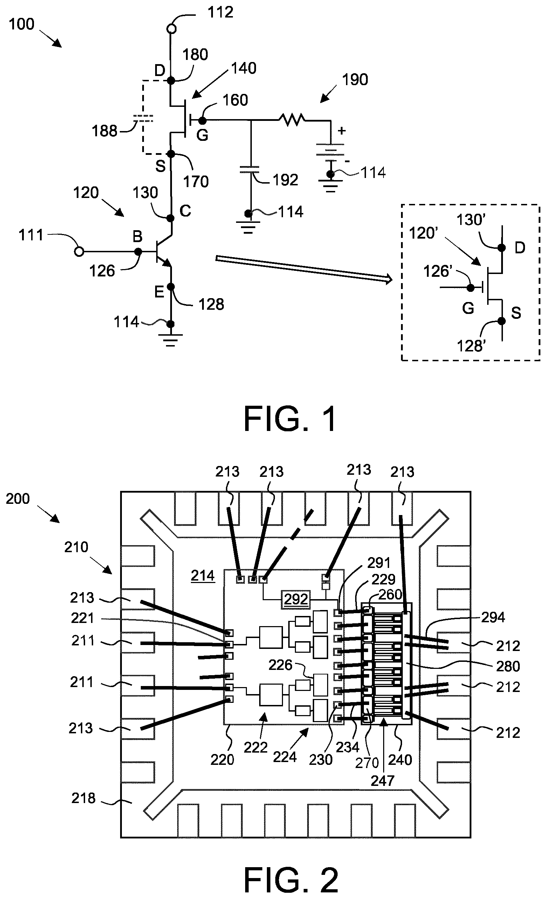

FIG. 1 is a simplified block diagram of a two-stage, cascode amplifier 100 with a common-emitter amplification stage (input stage) that drives a common-gate amplification stage (output stage), according to one or more embodiments. As indicated in the dashed box in the lower right corner of FIG. 1, according to one or more other embodiments, the cascode amplifier 100 may include a common-source amplification stage (input stage) that drives a common-gate amplification stage (output stage). Essentially, the cascode amplifier 100 is a cascading of a common-emitter amplifier (or a common-source amplifier) driving a common-gate amplifier.

The amplifier 100 has an input node 111, an output node 112, and one or more voltage reference nodes 114 (e.g., ground reference nodes). The input node 111 is configured to receive an input signal (e.g., a radio frequency (RF) signal). After amplification of the input signal through the amplifier 100, the output node 112 is configured to produce an amplified output signal (referred to below as an amplifier output signal). The voltage reference node(s) 114 are configured to be coupled to ground or to another voltage reference.

According to one or more embodiments, a common-emitter or common-source amplification stage (or input stage) of amplifier 100 is configured to apply a first gain to (i.e., to amplify) the input signal. For example, the input stage may be configured to apply a gain in a range of about 10 decibels (dB) to about 25 dB to the input signal (e.g., about 20 dB, in some embodiments), although the gain applied by the input stage may be lower or higher, as well.

The input stage may be implemented using one or more transistors. For example, FIG. 1 illustrates an embodiment in which the input stage is common-emitter amplification stage implemented with a single transistor 120 in the form of a heterojunction bipolar transistor (HBT). The transistor 120 has a base terminal 126, an emitter terminal 128, and a collector terminal 130. To establish transistor 120 in a common-emitter configuration, the base terminal 126 is electrically coupled to the input node 111, the emitter terminal 128 is electrically coupled to a voltage reference node 114 (e.g., to ground or another voltage reference), and the collector terminal 130 is electrically coupled to the common-gate amplification stage (or output stage), described below.

As shown in the dashed box in the lower right corner of FIG. 1, according to an alternate embodiment, the input stage is common-source amplification stage implemented with a single transistor 120' in the form of a field effect transistor (FET). The transistor 120' has a gate terminal 126', a source terminal 128', and a drain terminal 130'. To establish transistor 120' in a common-source configuration, the gate terminal 126' is electrically coupled to the input node 111, the source terminal 128' is electrically coupled to a voltage reference node 114 (e.g., to ground or another voltage reference), and the drain terminal 130' is electrically coupled to the common-gate amplification stage (or output stage), described below.

With the electrical connections described above, transistor 120 (or 120') is considered to be in a "common-emitter" (or "common-source") configuration. Transistor 120 (or 120') may be implemented using any of a variety of semiconductor materials. According to one or more embodiments, for example, transistor 120 (or 120') may be implemented as a silicon-germanium (SiGe) transistor, although transistor 120 (or 120') may be implemented using other semiconductor technologies, as well.

During operation, for the BJT implementations, the input signal received at the base terminal 126 modulates the conductivity of a variably-conductive channel between the emitter and collector terminals 128, 130, resulting in an amplified version of the input signal (referred to below as a second-stage driving signal) being produced at the collector terminal 130. Alternatively, for the FET implementations, the input signal received at the gate terminal 126' modulates the conductivity of a variably-conductive channel between the source and drain terminals 128', 130', resulting in an amplified version of the input signal being produced at the drain terminal 130'.

The common-gate amplification stage (or output stage) of amplifier 100 is configured to apply additional gain to (i.e., to further amplify) the second-stage driving signal. For example, the common-gate amplification stage may be configured to apply a gain in a range of about 10 dB to about 15 dB to the second-stage driving signal (e.g., about 14 dB, in some embodiments), yielding a total gain through the amplifier 100 in a range of about 20 dB to about 40 dB (e.g., about 35 dB, in some embodiments), although the gain applied by the common-gate amplification stage and/or the total amplifier gain may be lower or higher, as well.

The common-gate amplification stage also may be implemented using one or more transistors. For example, FIG. 1 illustrates a common-gate amplification stage implemented with a single transistor 140 in the form of a FET. The transistor 140 has a gate terminal 160, a source terminal 170, and a drain terminal 180. The source terminal 170 is electrically coupled to the collector terminal 130 of the common-emitter transistor 120 (or to the drain terminal 130' of the common-source transistor 120'), and the drain terminal 180 is electrically coupled to the output node 112. The gate terminal 160 is electrically coupled to a bias voltage circuit 190, which enables a suitable DC bias voltage to be applied to the gate terminal 160. According to one or more embodiments, the gate terminal 160 also is effectively grounded (in an RF sense) by coupling the gate terminal 160 to a voltage reference node 114 through a capacitor 192. According to one or more embodiments, the capacitor 192 has a capacitance value in a range of about 1.0 picofarads (pF) to about 10 pF. With the electrical connections described above, transistor 140 is considered to be in a "common-gate" configuration.

As will be discussed later, transistor 140 may be implemented using any of a variety of semiconductor materials. According to one or more embodiments, for example, transistor 140 may be implemented as a gallium nitride (GaN) transistor, although transistor 140 may be implemented using other semiconductor technologies, as well. GaN transistors commonly are depletion-mode, normally-on devices, which utilize specific bias voltage control circuits to generate a negative gate voltage to pinch the device off. According to some embodiments in which transistor 140 includes a depletion-mode, normally-on GaN transistor, the bias voltage circuit 190 may provide a negative DC gate voltage to pinch the device off (e.g., the bias voltage circuit 190 may be a negative DC bias circuit). In other embodiments in which transistor 140 includes an enhancement-mode, normally-off GaN transistor, the bias voltage circuit 190 may provide a positive DC gate voltage to turn the device on (e.g., the bias voltage circuit 190 may be a positive DC bias circuit).

During operation, the second-stage driving signal received from the common-emitter transistor 120 (or the common-source transistor 120') and applied to the source terminal 170 of the common-gate transistor 140 is amplified, resulting in an amplified version of the second-stage driving signal (referred to herein as the amplifier output signal) being produced at the drain terminal 180 and the output node 112. In other words, the signal applied across the gate-source junction of transistor 140 is amplified at the drain terminal 180.

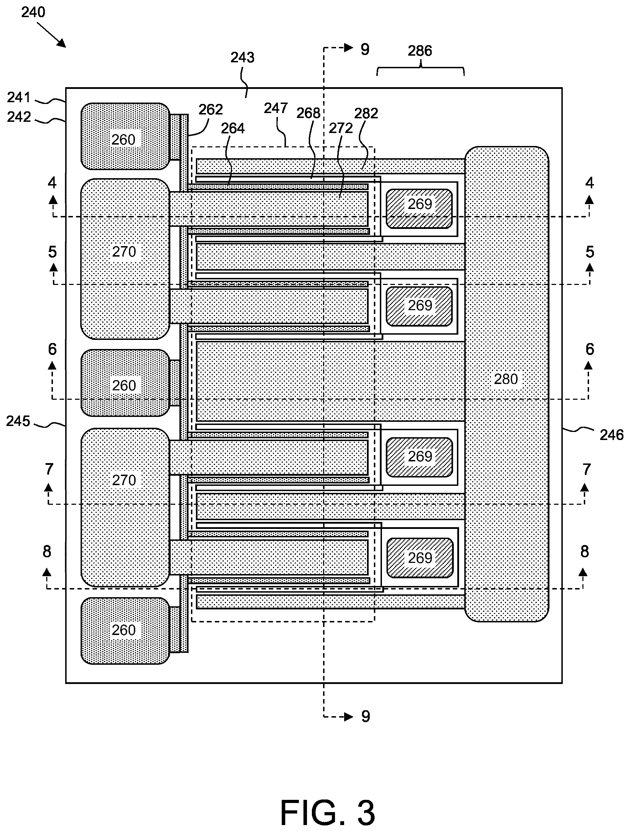

The common-gate transistor 140 is characterized by a drain-source capacitance 188, which is also commonly referred to as "feedback capacitance." In FIG. 1, the drain-source capacitance 188 is depicted using dashed lines to indicate that it is not a physical capacitor component, but instead is a parasitic capacitance resulting from the structural relationship between conductive drain and source features in the transistor 140. As indicated above, it is desirable to minimize the drain-source capacitance (feedback capacitance) of the output stage of a cascode amplifier for stable operation. As will be explained in detail later in conjunction with FIGs 3-9, embodiments of the inventive subject matter include transistors (e.g., transistor 247, FIGs 2-9) with transistor structures that cause the transistor to be characterized by reduced drain-source capacitance (e.g., capacitance 188, FIG. 1), when compared with conventional transistors and transistor structures.

The common-emitter transistor 120 (or common-source transistor 120') and common-gate transistor 140 may be implemented on one or more semiconductor dies (or "transistor dies"). In some embodiments, transistors 120 (or 120') and 140 may be implemented on the same semiconductor die, and may be interconnected using conductive interconnections within the die. In other embodiments, transistors 120 (or 120') and 140 may be implemented on separate semiconductor dies, and may be interconnected using conductive wirebonds (e.g., wirebonds 234, FIG. 2) and/or using conductive traces on a substrate (e.g., a printed circuit board, PCB) to which the semiconductor dies are coupled.

In various embodiments, cascode amplifier 100 may be physically implemented on a PCB or within a packaged semiconductor device. For example, FIG. 2 is a top view of a packaged amplifier device 200 within which a cascode amplifier (e.g., amplifier 100, FIG. 1) is implemented according to one or more embodiments. Thus, device 200 may be referred to herein as a cascode amplifier device 200 (or simply "amplifier device").

Amplifier device 200 includes a package body, which houses a cascode amplifier (e.g., amplifier 100, FIG. 1). In one or more embodiments, the amplifier device 200 may be a surface-mount device that is configured to be physically and electrically coupled to a system substrate (e.g., a system PCB). The package body may come in any of a number of forms, and the embodiment illustrated in FIG. 2 corresponds to a quad flat no-leads (QFN) package. In other embodiments, the package body may correspond to a dual flat no-leads (DFN) package, a Quad Flat Package (QFP), a Land Grid Array (LGA), a Ball Grid Array (BGA), or another suitable package type. In still other embodiments, the electrical components of the amplifier (e.g., dies 220, 240) may be coupled to a small PCB that corresponds to a support structure of an amplifier module.

In the illustrated package configuration, the package body includes a leadframe 210 with a plurality of conductive terminals or "lands" (e.g., terminals 211-213, described below) arranged around the outer perimeter of the package body, and a conductive flange 214 disposed generally in a center of the package body. The elements of the leadframe 210, and more particularly, the conductive terminals 211-213 and flange 214, may be electrically isolated from each other and held in a fixed physical arrangement by non-conductive encapsulation 218, which surrounds at least three sides of the terminals 211-213 and all four sides of the flange 214. According to one or more embodiments, the remaining side(s) of the terminals 211-213 may be exposed at the outer perimeter of the package body and/or at the bottom surface of the package body. Additionally, the top and bottom surfaces of the flange 214 may be exposed.

The flange 214 is a rigid electrically-conductive substrate formed from one or more solid or layered conductive materials. The flange 214 has a thickness that is sufficient to provide structural support for electrical components and elements contained within device 200. Further, the flange 214 has conductive top and bottom surfaces that are exposed through the encapsulation 218. To provide environmental protection, the internal circuitry (e.g., transistor dies 220, 240) and portions of the terminals 211-213 may be overmolded with additional non-conductive encapsulant (not shown). Alternatively, a non-conductive cap may be placed over the internal circuitry and portions of the terminals, resulting in the device package being classified as an air-cavity package.

The conductive flange 214 corresponds to a die-mounting surface of the amplifier device 200 (e.g., for transistor dies 220, 240). In addition, the conductive flange 214 may function as a ground reference node (e.g., node 114, FIG. 1) for the semiconductor dies and components contained within the device 200. Particularly, the flange 214 may operate as a ground reference node when it is coupled to an external system ground reference or to another voltage reference. Further still, the conductive flange 214 may function as a thermal dissipation structure to convey heat generated by the semiconductor dies toward the exterior (e.g., bottom surface) of the device 200, where a system thermal dissipation structure may be connected.

The conductive terminals 211-213 are configured to provide electrical connectivity between circuitry that is external to the device 200 (e.g., circuitry on or coupled to a PCB to which the device 200 is connected) and circuitry that is internal to the device 200 (e.g., transistor dies 220, 240, described below). In some embodiments, some of the conductive terminals (not numbered) also may be coupled to an external system ground, in order to provide a ground reference node.

The cascode amplifier housed within the device package includes a common-emitter or common-source amplification stage (input stage) that drives a common-gate amplification stage (output stage). To implement the cascode amplifier, the amplifier device 200 includes one or more input terminals 211 (e.g., corresponding to input node 111, FIG. 1), one or more output terminals 212 (e.g., corresponding to output node 112, FIG. 1), a first transistor die 220, a second transistor die 240, one or more bias terminals 213, and a ground reference node (e.g., the conductive flange 214 and/or one or more of the other, not-numbered terminals).

The input terminal(s) 211 are configured to receive an input signal (e.g., an RF signal). After amplification of the input signal by the transistors 224, 247 within the first and second transistor dies 220, 240, the output terminal(s) 212 are configured to produce an amplified output signal. The bias terminal(s) 213 may, for example, be configured to be coupled to one or more external bias voltage circuits. Through the bias terminals 213, the external bias voltage circuits are configured to provide bias voltages to the inputs and/or outputs of the transistors 224, 247 within the first and second transistor dies 220, 240.

The common-emitter or common-source amplification stage (or input stage) of amplifier device 200 may be implemented using one or more transistors integrated within one or more semiconductor dies. For example, FIG. 2 illustrates a common-emitter or common-source amplification stage that includes a single transistor 224, in the form of an HBT or a FET, which is implemented within a single semiconductor die 220.

The semiconductor die 220 includes a semiconductor substrate (not numbered) within which the various elements associated with the transistor 224 are integrally formed. The semiconductor substrate may include any of a number of different semiconductor materials. For example, but not by way of limitation, the semiconductor substrate for die 220 may include a silicon-based substrate (e.g., silicon (Si), silicon-germanium (SiGe), silicon-on-insulator (SoI), silicon carbide (SiC), and so on), a III-V-based substrate (e.g., gallium nitride (GaN), GaN on Si, GaN on SiC, gallium arsenide (GaAs), gallium phosphide (GaP), indium phosphide (InP), indium antimonide (InSb), and so on), or another suitable substrate. As used herein, a "silicon power transistor" or "silicon transistor" means a transistor in which the primary current-conducting channel is formed primarily from silicon semiconductor materials (e.g., Si, SiGe, SoI, SiC, etc.). Similarly, a "GaN power transistor" or "GaN transistor" means a transistor in which the primary current-conducting channel is formed primarily from GaN semiconductor materials.

The transistor elements of die 220 may include, for example, various conductive terminals (e.g., terminals 221, 230, 291), one or more impedance matching circuits 222, and the active transistor 224. One or more input terminals 211 of device 200 are electrically coupled (e.g., using wirebonds, as shown) to one or more input terminals 221 of transistor die 220. The input terminal(s) 221 of die 220, in turn, may be electrically coupled to the input (e.g., base or gate terminal 226) of transistor 224 through one or more input impedance matching circuits 222.

Although not shown in detail in FIG. 2, the transistor 224 may include an "active area" with a plurality of doped and not-intentionally-doped (NID) semiconductor regions that provide the functionality of the transistor 224. The transistor 224 also includes one or more base or gate terminals 226 (e.g., corresponding to base terminal 126 or gate terminal 126', FIG. 1), one or more emitter or source terminals (not numbered, e.g., corresponding to emitter terminal 128 or source terminal 128', FIG. 1), and one or more collector or drain terminals 230 (e.g., corresponding to collector terminal 130 or drain terminal 130', FIG. 1).

The transistor 224 within transistor die 220 is configured in a common-emitter or common-source configuration. Specifically, the base or gate terminal(s) 226 of the transistor 224 are electrically coupled to the input terminal(s) 211, the emitter or source terminal(s) (not numbered) are electrically coupled to a ground reference node (e.g., to flange 214), and the collector or drain terminal(s) 230 are electrically coupled to the common-gate amplification stage (or output stage), described below. During operation, various bias voltages may be provided through bias terminals 213 to establish the transistor 224 in a desired operational mode. An input signal received at the base or gate terminal 226 is amplified by the transistor 224 , resulting in an amplified version of the input signal (the second-stage driving signal) being produced at the collector or drain terminal(s) 230.

The common-gate amplification stage (or output stage) of amplifier device 200 also may be implemented using one or more transistors integrated within one or more semiconductor dies. For example, FIG. 2 illustrates a common-gate amplification stage that includes a single transistor 247, in the form of a FET, which is implemented within a single semiconductor die 240.

As will be discussed in more detail below in conjunction with FIGs 3-9, the semiconductor die 240 includes a semiconductor substrate within which the various elements associated with the transistor 247 are integrally formed. The semiconductor substrate may be based on any of a number of different semiconductor materials. For example, but not by way of limitation, the semiconductor substrate for die 240 may include a silicon-based substrate (e.g., Si, SoI, SiC, and so on), a III-V-based substrate (e.g., GaN, GaN on Si, GaN on SiC, GaAs, GaP, InP, InSb, and so on), or another suitable substrate.

In some embodiments, the type of semiconductor substrate for dies 220 and 240 may be the same (e.g., both dies 220 may be formed from Si or from GaN or from another semiconductor material). In other embodiments, the types of semiconductor substrates for dies 220 and 240 may be different. For example, according to one or more embodiments, the semiconductor substrate for die 220 may be a silicon-based substrate (e.g., SiGe), and the semiconductor substrate for die 240 may be a GaN-based substrate. A potential advantage for such an arrangement is that the common-emitter (or common-source) amplification stage may be implemented using a relatively inexpensive semiconductor material (e.g., SiGe), while the common-gate amplification stage may be implemented using a semiconductor material that is better suited to higher power operation (e.g., GaN).

The transistor elements of die 240 may include, for example, various conductive terminals (e.g., terminals 260, 270, 280) and the active transistor 247. To establish the cascode relationship between transistors 224 (in die 220) and 247 (in die 240), the collector or drain terminal(s) 230 of transistor 224 are electrically coupled (e.g., using wirebonds 234, as shown) to one or more source terminals 270 of transistor die 240. Further, to couple transistor 247 to the output terminal(s) 212 of device 200, the drain terminal(s) 280 of die 240 are electrically coupled to the output terminal(s) 212 through one or more wirebonds 294.

The gate terminal(s) 260 of the transistor 247 are electrically coupled to a ground reference node (e.g., to flange 214 or to a terminal configured to be coupled to system ground). According to one or more embodiments the gate terminal 260 is shorted to the ground reference through a capacitor 292 (e.g., capacitor 192, FIG. 1). As shown in FIG. 2, in one or more embodiments, and particularly when the semiconductor material for the first transistor die 220 is less expensive than the semiconductor material for the second transistor die 240 (e.g., die 220 is silicon-based, and die 240 is GaN), it may be desirable to implement the capacitor 292 on the first transistor die 220. For example, capacitor 292 may be implemented as an integrated metal-insulator-metal (MIM) capacitor formed within transistor die 220, and/or as one or more small chip capacitors (discrete capacitors) coupled to the top surface of the die 220, in various embodiments.

The connection between the gate terminal 260 of transistor 247 and a first terminal of the capacitor 292 may be made through one or more "bond back" wirebonds 229, a "bond back" terminal 291 on the first transistor die 220, and conductive traces within the die 220. The connection between the second terminal of the capacitor 292 and the ground reference node may be made through additional conductive traces within the die 220, an additional terminal (not numbered) on the die 220, and one or more additional wirebonds (not numbered) between the additional terminal and the flange 214 (or between the additional terminal and a terminal of device 200 that is configured to be coupled to system ground). According to one or more other embodiments, the capacitor 292 may be implemented in a discrete integrated passive device (IPD) that is separately mounted to the flange 214.

The gate terminal 260 of transistor 247 also is electrically coupled to a bias voltage circuit (e.g., circuit 190, FIG. 1), which enables a suitable DC bias voltage to be applied to the gate terminal 260. According to one or more embodiments, the bias connection may be made through the above-mentioned "bond back" wirebonds 229, an additional terminal (not numbered) on the first die 220, and one or more additional wirebonds (not numbered) between the additional terminal and a bias terminal 213. Alternatively, the gate terminal 260 may be directly coupled to a bias terminal 213 with one or more wirebonds. Either way, the above-described connections establish the transistor 247 within transistor die 240 in a common-gate configuration.

During operation, gate bias voltages may be provided through bias terminals 213 and drain bias voltages may be provided through output terminal(s) 212 to establish the transistor 247 in a desired operational mode. A second stage driving signal received from the first transistor die 220 at the source terminal 270 of the transistor 247 is amplified through transistor 247, and the amplified output signal is produced at the drain terminal(s) 280 of the second transistor die 240 and at the output terminal(s) 212 of device 200.

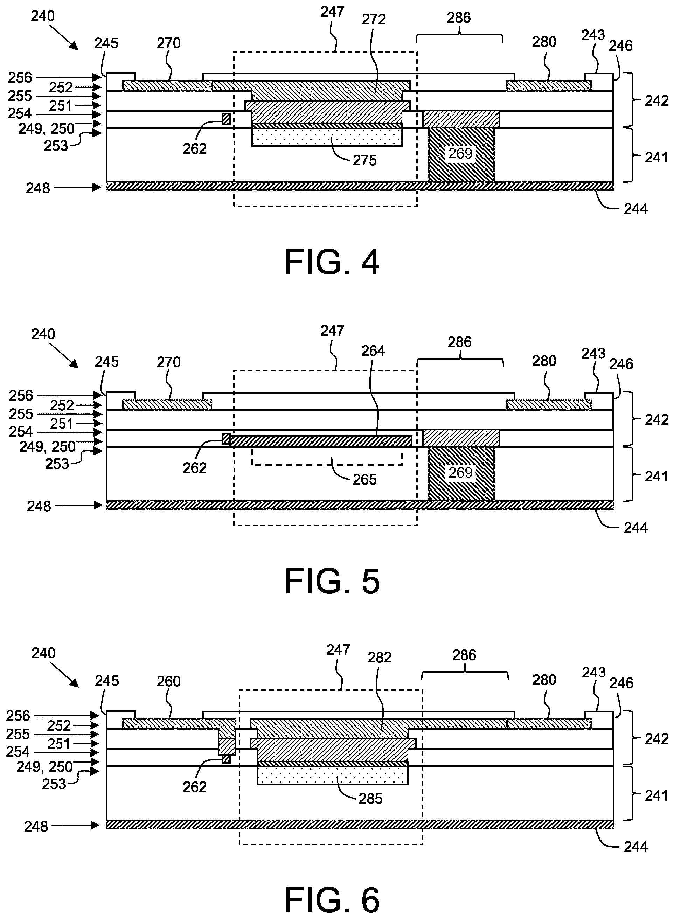

Referring now to FIGs 3-9, various embodiments of the second transistor die 240 are illustrated. More specifically, FIG. 3 is an enlarged top view of the transistor die 240 of FIG. 2, in accordance with an example embodiment, and FIGs 4-9 are side cross-sectional views of the transistor die 240 along lines 4-4, 5-5, 6-6, 7-7, 8-8, and 9-9, respectively.

As will be explained in more detail below, the transistor 247 that is integrally formed within transistor die 240 may be characterized by a relatively low feedback capacitance (e.g., drain-source capacitance) during operation, in comparison to other conventional transistors. This is achieved, in one or more embodiments, by including a conductive field plate 268 between a transistor gate 264 and an adjacent transistor drain contact 282, and by electrically coupling the field plate 268 to a ground reference node of the transistor die 240. During operation, the field plate 268 may function as an electromagnetic shield between the transistor source and drain contacts 272, 282. Utilizing the inventive features of the various embodiments may result in a substantial reduction in the drain-source capacitance (feedback capacitance) of the transistor 247 within transistor die 240, making embodiments of transistor 247 well suited for use in a common-gate configuration in a cascode amplifier (e.g., amplifier 100, FIG. 1) or a cascode amplifier device (e.g., device 200, FIG. 2). Embodiments of a cascode amplifier that includes embodiments of transistor 247 may be characterized by better stability, when compared with cascode amplifiers that utilize conventional transistors.

As a recap, transistor die 240 includes a semiconductor substrate, one or more gate terminals 260 (e.g., corresponding to gate terminal 160, FIG. 1), one or more source terminals 270 (e.g., corresponding to source terminal 170, FIG. 1), one or more drain terminals 280 (e.g., corresponding to drain terminal 180, FIG. 1), and a transistor 247 within an active area of the die 240. In FIGs 3-9, the boundaries of the active area are depicted with a dashed rectangular box.

The semiconductor substrate essentially is a cuboid with a top surface 243, a bottom surface 244, and side surfaces that extend between the top and bottom surfaces 243, 244. The side surfaces include a first side surface 245 and a second side surface 246 on an opposite side of the semiconductor substrate from the first side surface 245.

As best seen in FIGs 4-9, the semiconductor substrate may specifically include a base semiconductor substrate 241 (or "base substrate") and a build-up structure 242 formed on an upper surface of the base semiconductor substrate 241. As indicated above, the base semiconductor substrate 241 may include a silicon-based substrate (e.g., Si, SoI, SiC, and so on), a III-V-based substrate (e.g., GaN, GaN on Si, GaN on SiC, GaAs, GaP, InP, InSb, and so on), or another suitable substrate. More specifically, the base semiconductor substrate 241 may include a bulk semiconductor material upon which a plurality of epitaxial semiconductor layers are grown. Those epitaxial semiconductor layers may include, for example, silicon-based and/or III-V-based semiconductor materials. According to one or more specific embodiments, the epitaxial semiconductor layers include one or more GaN-containing layers. In such embodiments, the transistor 247 may be referred to as a "GaN transistor."

According to one or more embodiments, one or more conductive through substrate vias (TSVs) 269 extend between the top and bottom surfaces of the base semiconductor substrate 241 to provide one or more conductive paths between the top and bottom surfaces of the base semiconductor substrate 241. More specifically, proximal ends of the TSVs 269 may be exposed at a top surface of the base semiconductor substrate 241, and distal ends of the TSVs 269 may be exposed at a bottom surface of the base semiconductor substrate 241. In one or more embodiments, the TSVs 269 are located between the second side surface 246 of the die 240 and the transistor 247 in the active area. More specifically, in some embodiments, the TSVs 269 may be located in a gap 286 between the transistor 247/active area and the below-described drain terminal 280. In other embodiments, the TSVs 269 may be located between the first side surface 245 of the die 240 and the transistor 247 in the active area.

Within the active area of the transistor 247, the transistor 247 includes a plurality of doped and NID semiconductor regions that provide the functionality of the transistor 247. For example, the transistor 247 may include a plurality of elongated source regions 275 (FIG. 4) and a plurality of elongated drain regions 285 (FIG. 6), adjacent pairs of which are separated by elongated channel regions 265 (FIG. 5). These regions 265, 275, 285 are coupled to transistor gates 264, source contacts 272, and drain contacts 282, respectively, as will be described in more detail below. As used herein, a "transistor finger" refers to a combination of a single source region 275, a single drain region 285, a single channel region 265, a single gate 264, a single source contact 272, a single drain contact 282, and a single field plate 266. As can be seen in FIGs 2 and 3, within the active area, the transistor 247 includes eight transistor fingers arranged in parallel. Other transistor embodiments may have as few as one transistor finger, or may include more than eight transistor fingers.

According to an embodiment, a conductive layer 248 is coupled to the bottom surface of the base semiconductor substrate 241, and the distal ends of the TSVs 269 are connected to the conductive layer 248. The conductive layer 248 may function as a ground node for the die 240 (e.g., corresponding to ground node 114, FIG. 1). In addition, the conductive layer 248 may be utilized to physically, electrically, and thermally couple the die 240 to an external structure, such as flange 214 (FIG. 2). In other embodiments, the conductive layer 248 enables the die 240 to be coupled to a corresponding conductive structure within a PCB on which the die 240 is mounted.

The build-up structure 242 is formed on the top surface of the base semiconductor substrate 241. The build-up structure 242 may include, for example, a plurality of dielectric layers 253, 254, 255, 256 and patterned conductive layers 249, 250, 251, 252, where the dielectric and conductive layers generally are deposited in an alternating arrangement (in a vertical direction). The dielectric layers may include a surface passivation layer 253 coupled to the top surface of the base semiconductor substrate 242, and a plurality of overlying "interlayer" dielectric layers 254-256 formed over the surface passivation layer 253. Portions of different patterned conductive layers 249-252, which are arranged in an alternating manner with the dielectric layers 254-256, may be electrically coupled with conductive vias (not numbered) that extend through the dielectric layers 254-256. Although the illustrated embodiments show four dielectric layers 253-256 and four patterned conductive layers 249-252 in the build-up structure 242, more or fewer dielectric and/or conductive layers may be implemented, in other embodiments.

According to one or more embodiments, the gate terminal(s) 260, source terminal(s) 270, and drain terminal(s) 280 are formed from portions of the uppermost conductive layer 252 of the build-up structure 242, and are exposed at the top surface 243 of the transistor die 240 through openings in the uppermost dielectric layer 256. As best seen in FIG. 3, a plurality of gate terminals 260, a plurality of source terminals 270, and a single drain terminal 280 are implemented, in the illustrated embodiment. The gate and source terminals 260, 270 may be implemented as bond pads that are configured for attachment of wirebonds (e.g., wirebonds 229, 234, FIG. 2). The gate and source terminals 260, 270 are spaced apart from each other and arranged in an alternating sequence along an axis that is parallel with the first side surface 245 of the die 240. Further, the gate and source terminals 260, 270 are located between the first side surface 245 of the die 240 and the transistor 247 within the active area. The drain terminal 280 is located between the second side surface 246 of the die 240 and the transistor 247 within the active area. The drain terminal 280 also may be implemented as a bond pad that is configured for attachment of wirebonds (e.g., wirebonds 294, FIG. 2). Although three gate terminals 260 and two source terminals 270 are shown in FIG. 3, more or fewer gate terminals 260 and/or source terminals 270 may be implemented, in other embodiments. Further, although a single drain terminal 280 is shown in FIG. 3, more than one drain terminal 280 may be implemented, in other embodiments.

As best seen in FIGs 3, 5, and 9, within the portion of the build-up structure 242 that overlies the active area of the die 240, the transistor 247 also includes a plurality of elongated conductive gates 264 that overlie the channel regions 265. In some embodiments, the gates 264 directly contact the channel regions 265 at the top surface of the base semiconductor substrate 241. In other embodiments, a thin dielectric layer (not shown) may be deposited between the channel regions 265 and the gates 264 (e.g., in such embodiments, the transistor 247 is an insulated gate FET, IGFET).

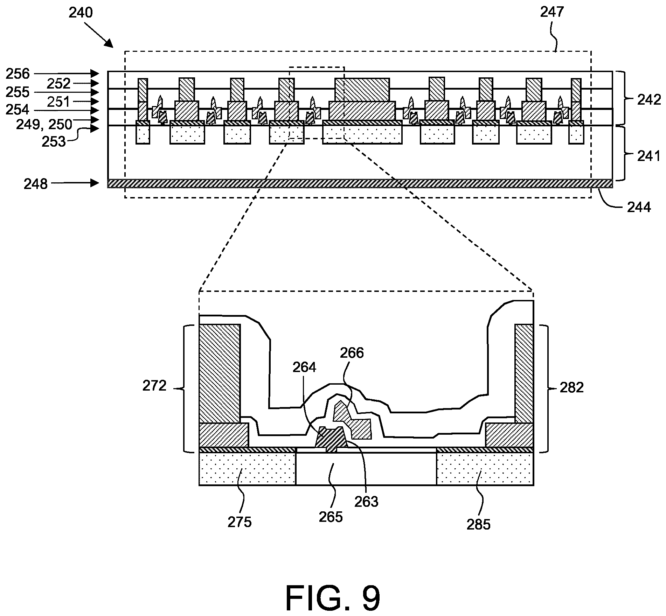

Either way, each gate 264 extends over a channel region 265 from a proximal end of the gate 264 (i.e., an end that is closest to the first side surface 245) to a distal end of the gate 264 (i.e., an end that is closest to the second side surface 246). As best seen in FIG. 9, in some embodiments, each gate 264 may have a "T" shaped cross-section, which includes a lower vertical stem portion that extends through an opening in the passivation layer 253 to contact the channel region 265, and an upper portion that overlies the opening in the passivation layer 253 and extends outward over the top of the passivation layer 253 on both sides of the vertical stem portion.

As best seen in FIG. 3, the proximal ends of the gates 264 are electrically coupled to a conductive gate manifold 262. The gate manifold 262 may overlie the passivation layer 253, or some portions of the gate manifold 262 may extend through the passivation layer 253 to contact the top surface of the base semiconductor substrate 241. The gate manifold 262 is an elongated conductive feature that extends along an axis that is parallel with the first side surface 245 of the semiconductor substrate. In some embodiments, the gate manifold 262 is located between the transistor 247/active area and the gate and source terminals 260, 270. In some embodiments, a single gate manifold 262 may be utilized, which extends along substantially an entire width of the die 240 to enable the proximal ends of all of the gates 264 to be coupled along the gate manifold 262. In other embodiments, an aligned series of multiple gate manifolds alternatively may be utilized. As will be discussed later, and as best seen in FIG. 4, portions of the gate manifold 262 may extend underneath portions of metallization that connect the source contacts 270 to the source regions 275 (e.g., at a cross-section through the gate manifold 262, the gate manifold 262 is formed from a lower conductive layer than the source metallization).

According to one or more embodiments, both the gates 264 and the gate manifold 262 are formed from portions of conductive layer 250. More specifically, and referring to FIGs 5 and 9, conductive layer 250 may include one or more layers of conductive "gate metal" material (e.g., one or more layers of gold, silver, aluminum copper, titanium, or other suitable materials), which are deposited over the passivation layer 253 and into the above-mentioned openings in the passivation layer 253 (i.e., openings in layer 253 that expose the channel regions 254).

As best seen in FIGs 3 and 6, the gate manifold 262, and thus the gates 265, are electrically coupled to the gate terminal(s) 260. For example, conductive vias and traces formed from portions of overlying conductive layers 251, 252 in the build-up structure 242 may provide an electrically-conductive path between the gate manifold 262/gates 265 and the gate contacts 260.

As best seen in FIGs 3, 4, and 9, within the portion of the build-up structure 242 that overlies the active area of the die 240, the transistor 247 also includes a plurality of elongated conductive source contacts 272 that overlie the source regions 275. In some embodiments, the source contacts 272 include portions of an ohmic metal layer 249 that are deposited within openings in the passivation layer 253, and these portions of the ohmic metal layer 249 directly contact the source regions 275. In FIGs 4 and 9, the ohmic metal layer portions are illustrated with a thin layer of material with bold upper-left to lower-right cross-hatching. In addition, the source contacts 272 may include portions of one or more overlying conductive layers 251, 252 deposited on and over the ohmic metal layer 249. Portions of the overlying conductive layers 251, 252 that extend through openings in the dielectric layers 254-256 may provide conductive vias between the layers 250, 251, 252.

Either way, each source contact 272 extends over a source region 275 from a proximal end of the source contact 272 (i.e., an end that is closest to the first side surface 245) to a distal end of the source contact 272 (i.e., an end that is closest to the second side surface 246). As best seen in FIG. 4, the source contacts 272 are electrically coupled to the source terminals 270. For example, conductive portions of one or more of the overlying conductive layers 251, 252 in the build-up structure 242 may provide an electrically-conductive path between the source contacts 272 (and the source regions 275) and the source terminals 270.

As mentioned previously, portions of the gate manifold 262 may extend underneath portions of source metallization that connect the source contacts 270 to the source regions 275. For example, as shown in FIG. 4, portions of an uppermost conductive layer 252 that provides an electrical connection between the source contacts 272 and the source terminals 270 overlies the gate manifold 262. In such embodiments, the gate manifold 262 and the overlying source metallization are electrically separated from each other by dielectric layers 254, 255.

As best seen in FIGs 3, 6, 7, and 9, within the portion of the build-up structure 242 that overlies the active area of the die 240, the transistor 247 also includes a plurality of elongated conductive drain contacts 282 that overlie the drain regions 285. In some embodiments, the drain contacts 282 include portions of the above-mentioned ohmic metal layer 249 that are deposited within openings in the passivation layer 253, and these portions of the ohmic metal layer 249 directly contact the drain regions 285. In FIGs 6, 7, and 9, the ohmic metal layer portions are illustrated with a thin layer of material with bold upper-left to lower-right cross-hatching. In addition, the drain contacts 282 may include portions of one or more overlying conductive layers 251, 252 deposited on and over the ohmic metal layer 249. Again, portions of the overlying conductive layers 251, 252 that extend through openings in the dielectric layers 254-256 may provide conductive vias between the layers 250, 251, 252.

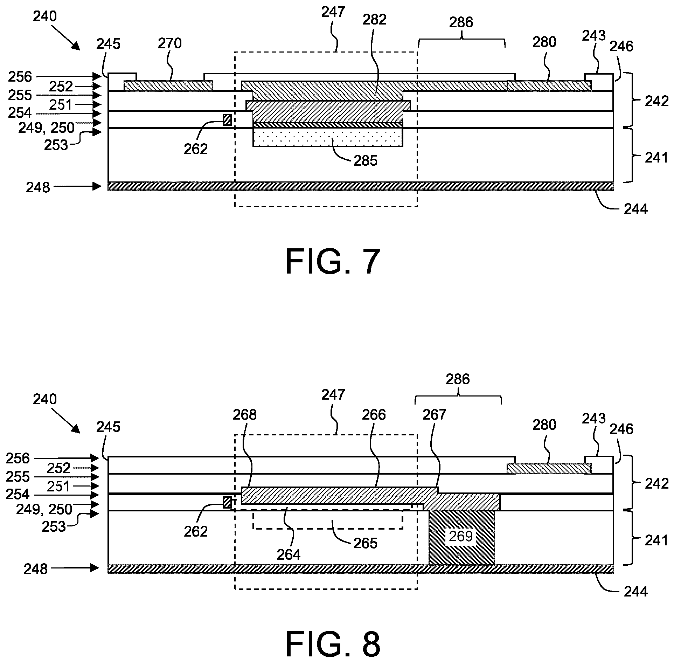

Each drain contact 282 extends over a drain region 285 from a proximal end of the drain contact 282 (i.e., an end that is closest to the second side surface 246) to a distal end of the drain contact 282 (i.e., an end that is closest to the first side surface 245). As best seen in FIGs 6 and 7, the drain contacts 282 are electrically coupled to the drain terminals 280. For example, conductive portions of one or more of the overlying conductive layers 251, 252 in the build-up structure 242 may provide an electrically-conductive path between the drain contacts 282 (and the drain regions 285) and the drain terminals 280.

According to an embodiment, a gap 286 is present between the transistor 247 within the active area and the drain contacts 280. As shown in FIGs 3, 6, and 7, portions of an uppermost conductive layer 252 that provides an electrical connection between the drain contacts 282 and the drain terminals 280 extend across this gap 286. Further, as will be discussed in more detail below, the TSVs 269 may be located within this gap 286 in the spaces between the electrical connections between the drain contacts 282 and the drain terminals 280, according to one or more embodiments.

As indicated in the discussion of FIG. 1, transistor 247 is characterized by a drain-source capacitance (e.g., capacitance 188, FIG. 1), which is a parasitic capacitance resulting from the structural relationship between conductive drain and source features in the transistor 247 (e.g., parasitic capacitance between the drain and source contacts 282, 272). According to one or more embodiments, the drain-source capacitance within transistor 247 is reduced, in comparison with conventional transistors, by including a ground-connected field plate 266 within the build-up structure 242 between the source contacts 272 and the drain contacts 282, and more specifically between the gates 264 and the drain contacts 282.

As best seen in FIGs 3, 8, and 9, the field plates 266 include elongated conductive structures that are proximate to, but electrically separated from, the gates 264 with dielectric material (e.g., with portions of dielectric layer 254). A thickness of the dielectric material between the gates 264 and the field plates 266 may be in a range of about 0.3 microns to about 0.4 microns, for example, although the thickness of dielectric material may be smaller or larger, as well. Further, bottom extents of the field plates 266 are electrically separated from the top surface of the base semiconductor substrate 241 by additional dielectric material (e.g., with portions of passivation and dielectric layers 253, 254). A thickness of the dielectric material between the top surface of the base semiconductor substrate 241 and the bottom extents of the field plates 266 may be in a range of about 0.3 microns to about 0.8 microns, for example, although the thickness of dielectric material may be smaller or larger, as well.

The field plates 266 may be formed, for example, from patterned portions of one or more of the conductive layers (e.g., from portions of layer 251 and/or another conductive layer). For example, the field plates 266 (and the conductive layer 251) may be formed from one or more layers of Ti, Al, TiN, TiW, TiAl, and/or TiWN, Au, Mo, Ni, Si, Ge, Pt, Ta, Cu, Au, Ag, and/or other suitable materials.

According to some embodiments, within each transistor finger, the field plates 266 are located between a drain-side edge 263 (FIG. 9) of the gate 264 and the adjacent drain contact 282, where the "drain-side edge" is defined as the edge or side of a gate 264 that faces the drain and drain contact (as opposed to the source and source contact). An "overlapping" portion of the field plate 266 may extend over the top surface of the gate 264. As best seen in FIG. 9, for example, an overlapping portion of the field plate 266 may extend over the gate 264 to about the mid-point of the top surface of the gate 264. Alternatively, an overlapping portion of a field plate 266 may extend a shorter distance over the gate 264, or may extend a farther distance over the gate 264 (e.g., over an entire top surface of the gate 264). Another "downward extending" portion of the field plate 266 may extend from the overlapping portion downward and adjacent to the drain-side edge 263 of the gate 264. The downward extending portion of the field plate 266 is continuous along the entire length of the field plate 266.

The overlapping portion of a field plate 266 may extend over the gate 264 for the entire length of the field plate 266 (e.g., the horizontal dimension of the field plate 266 in FIG. 8) and the entire length of the gate 264 (e.g., the horizontal dimension of the gate 264 in FIG. 5), in some embodiments. Such a "fully-overlapping" field plate 266 may have the advantage of maximizing a reduction in drain-source capacitance. Alternatively, the overlapping portion of the field plate 266 may be implemented as a plurality of conductive "straps" that only overlap the top surface of the gate 264 at certain points along the length of the field plate 266.

Either way, each field plate 266 extends at least partially over and adjacent to a gate 264 from a proximal end 267 (FIG. 8) of the field plate 266 (i.e., an end that is closest to the second side surface 246) to a distal end 268 (FIG. 8) of the field plate 266 (i.e., an end that is closest to the first side surface 245). The distal end 268 of each field plate 266 may be electrically floating (i.e., not coupled to any further circuitry beyond the distal end 268). In contrast, the proximal end 267 of each field plate 266 is electrically coupled to a ground reference node, according to one or more embodiments.

More particularly, as best seen in FIGs 3 and 8, and according to one or more embodiments, within the build-up structure 242, the proximal end 267 of each field plate 266 is electrically coupled to a proximal end of a TSV 269. This electrical coupling may be achieved, for example, with a conductive via formed from a portion of the conductive layer from which the field plate 266 is formed (e.g., conductive layer 251) that extends into an opening through dielectric layers 253, 254, where that opening exposes the proximal end of the TSV 269. In this manner, the proximal end 267 of each field plate 266 is electrically coupled to the proximal end of a TSV 269. As discussed previously, the distal end of each TSV 269 may be coupled to the conductive layer 248 on the bottom surface of the base semiconductor substrate 241. Accordingly, the field plates 266 also are electrically coupled to the conductive layer 248 through the TSVs 269.

When included, the conductive layer 248 functions as a ground reference node for the transistor die 240, and specifically for the field plates 266. In other embodiments in which the conductive layer 248 is omitted, the distal ends of the TSVs 269 may function as ground reference nodes for the die 240 and field plates 266.

As discussed in conjunction with FIG. 2, the transistor die 240 may be physically and electrically coupled to an external ground reference node (e.g., to flange 214, FIG. 2) by physically and electrically connecting the conductive layer 248 (or the distal ends of TSVs 269) to the external ground reference node. For example, transistor die 240 may be mounted to flange 214 (FIG. 2) using solder, sinter, or other electrically-conductive die-mounting materials. When flange 214, in turn, is physically and electrically coupled to a system ground reference (e.g., a ground reference for a PCB to which device 200 is coupled), the transistor die 240 and the field plates 266 also are coupled to the system ground reference.

The above-described embodiments of transistor 247 may be characterized by a relatively low feedback capacitance (e.g., drain-source capacitance) during operation, in comparison with other conventional transistors. This is achieved, in one or more embodiments, by including the field plate 266 between the source and drain contacts 272, 282 (and more specifically, between the gate 264 and the drain contact 282), and by electrically coupling the field plate 266 through a TSV 269 to a ground reference node of the transistor (e.g., conductive layer 248). During operation, the field plate 266 may function as a grounded electromagnetic shield between the transistor source and drain contacts 272, 282. By way of summary, utilizing the inventive features of the various embodiments may result in a substantial reduction in the drain-source capacitance of a transistor, making such transistor embodiments well suited for use in a common-gate configuration in a cascode amplifier. Again, an embodiment of a cascode amplifier that includes such a transistor may be characterized by better stability, when compared with conventional cascode amplifiers.

An embodiment of a transistor die includes a semiconductor substrate with first and second side surfaces, a transistor within an active area in the semiconductor substrate between the first and second side surfaces, one or more gate terminals and one or more source terminals exposed at a top surface of the semiconductor substrate between the active area and the first side surface, at least one drain terminal exposed at the top surface of the semiconductor substrate between the active area and the second side surface, and one or more TSVs between the active area and the at least one drain terminal. The semiconductor substrate has a top surface, a bottom surface, the first side surface extending between the top and bottom surfaces, the second side surface extending between the top and bottom surfaces, a base substrate, and a build-up structure integrally formed on the base substrate. The transistor includes multiple transistor fingers, and each transistor finger includes a source region, a drain region, a channel region between the source region and the drain region, a gate overlying the channel region, a source contact overlying the source region, a drain contact overlying the drain region, and a field plate in the build-up structure between the gate and the drain contact. The gate of each of the multiple transistor fingers is electrically coupled to the one or more gate terminals. The source contact of each of the multiple transistor fingers is electrically coupled to the one or more source terminals. Each TSV extends between a proximal end at a top surface of the base substrate and a distal end at a bottom surface of the base substrate. Each field plate of the multiple transistor fingers is electrically coupled through the build-up structure to the proximal end of a TSV.

According to a further embodiment, each field plate of the multiple transistor fingers is an elongated conductive feature that has a proximal end and a distal end, wherein the proximal end of the field plate is coupled to the proximal end of the TSV, and the distal end of the field plate is electrically floating.

An embodiment of an amplifier device includes a substrate, an input terminal, an output terminal, a ground reference node, and a first transistor die coupled to the substrate. The first transistor die includes a semiconductor substrate with first and second side surfaces, a transistor within an active area in the semiconductor substrate between the first and second side surfaces, one or more gate terminals, one or more source terminals, at least one drain terminal, and one or more TSVs. The semiconductor substrate has a top surface, a bottom surface, the first side surface extending between the top and bottom surfaces, the second side surface extending between the top and bottom surfaces, a base substrate, and a build-up structure integrally formed on the base substrate. The transistor includes multiple transistor fingers, and each transistor finger includes a source region, a drain region, a channel region between the source region and the drain region, a gate overlying the channel region, a source contact overlying the source region, a drain contact overlying the drain region, and a field plate in the build-up structure between the gate and the drain contact. The gate of each of the multiple transistor fingers is electrically coupled to the one or more gate terminals. The source contact of each of the multiple transistor fingers is electrically coupled to the one or more source terminals. Each TSV extends between a proximal end at a top surface of the base substrate and a distal end at a bottom surface of the base substrate. Each field plate of the multiple transistor fingers is electrically coupled through the build-up structure to the proximal end of a TSV.

According to a further embodiment, the amplifier device also includes a second transistor die coupled to the substrate. The second transistor includes a second transistor with a second gate terminal, a second source terminal, and a second drain terminal. The second gate terminal is electrically coupled to the input terminal, the second source terminal is electrically coupled to the ground reference node, and the second drain terminal is electrically coupled to the one or more first source terminals of the first transistor die.

According to another further embodiment, the first transistor has a common-gate configuration, the second transistor has a common-emitter or common-source configuration, and the first and second transistors are electrically coupled together to form a cascode amplifier.

The preceding detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A transistor die (240) comprising:
a semiconductor substrate that includes a top surface (243), a bottom surface (244), a first side surface (245) extending between the top and bottom surfaces, a second side surface (246) extending between the top and bottom surfaces, a base substrate (241), and a build-up structure (242) integrally formed on the base substrate;
a transistor (247) within an active area in the semiconductor substrate between the first and second side surfaces, wherein the transistor includes multiple transistor fingers, and each transistor finger includes a source region (275), a drain region (285), a channel region (265) between the source region and the drain region, a gate (264) overlying the channel region, a source contact (272) overlying the source region, a drain contact (282) overlying the drain region, and a field plate (266) in the build-up structure between the gate and the drain contact;
one or more gate terminals (260), wherein the gate of each of the multiple transistor fingers is electrically coupled to the one or more gate terminals;
one or more source terminals (270), wherein the source contact of each of the multiple transistor fingers is electrically coupled to the one or more source terminals;
at least one drain terminal (280); and
one or more through-substrate vias (269), TSVs, wherein each TSV of the one or more TSVs extends between a proximal end at a top surface of the base substrate and a distal end at a bottom surface of the base substrate, and
wherein each field plate of the multiple transistor fingers is electrically coupled through the build-up structure to the proximal end of a TSV of the one or more TSVs.

2. The transistor die of claim 1, wherein:
the one or more gate terminals are exposed at the top surface of the semiconductor substrate between the active area and the first side surface;
the one or more source terminals are exposed at the top surface of the semiconductor substrate between the active area and the first side surface;
the at least one drain terminal is exposed at the top surface of the semiconductor substrate between the active area and the second side surface; and
the one or more TSVs are located in a gap between the active area and the second side surface.

3. The transistor die of claim 1 or 2, wherein:
the one or more gate terminals include multiple gate terminals;
the one or more source terminals include multiple source terminals; and
the multiple gate terminals and the multiple source terminals are arranged in an alternating sequence along an axis that is parallel with the first side surface.

4. The transistor die of any of the preceding claims, wherein each field plate of the multiple transistor fingers is an elongated conductive feature that has a proximal end (267) and a distal end (268), wherein the proximal end of the field plate is coupled to the proximal end of the TSV, and the distal end of the field plate is electrically floating.

5. The transistor die of any of the preceding claims, further comprising:
a conductive layer (248) on the bottom surface of the base substrate, wherein the distal end of each of the one or more TSVs is coupled to the conductive layer.

6. The transistor die of any of the preceding claims, further comprising:
a gate manifold (262) between the multiple gate terminals and the active area, wherein the gate manifold extends along an axis that is parallel with the first side surface of the semiconductor substrate, and wherein the gate of each of the multiple transistor fingers is electrically coupled to the gate manifold.

7. The transistor die of claim 6, further comprising:
source metallization (272) that electrically couples the one or more source terminals to the source region of each of the multiple transistor fingers, wherein the gate manifold extends underneath portions of the source metallization, and the source metallization overlies the gate manifold.

8. An amplifier device (200) comprising:
a substrate (214);
an input terminal (211);
an output terminal (212);
a ground reference node (213, 214); and
a first transistor die (240) coupled to the substrate, wherein the first transistor die includes
a semiconductor substrate that includes a top surface (243), a bottom surface (244), a first side surface (245) extending between the top and bottom surfaces, a second side surface (246) extending between the top and bottom surfaces, a base substrate (241), and a build-up structure (242) integrally formed on the base substrate,
a first transistor (247) within an active area in the semiconductor substrate between the first and second side surfaces, wherein the first transistor includes multiple transistor fingers, and each transistor finger includes a source region (275), a drain region (285), a channel region (265) between the source region and the drain region, a gate (264) overlying the channel region, a source contact (272) overlying the source region, a drain contact (282) overlying the drain region, and a field plate (266) in the build-up structure between the gate and the drain contact,
one or more first gate terminals (260), wherein the gate of each of the multiple transistor fingers is electrically coupled to the one or more first gate terminals,
one or more first source terminals (270), wherein the source contact of each of the multiple transistor fingers is electrically coupled to the one or more first source terminals,
at least one first drain terminal (280), wherein the at least one first drain terminal is electrically coupled to the output terminal, and
one or more through-substrate vias (269), TSVs, wherein each TSV of the one or more TSVs extends between a proximal end at a top surface of the base substrate and a distal end at a bottom surface of the base substrate, and
wherein each field plate of the multiple transistor fingers is electrically coupled through the build-up structure to the proximal end of a TSV of the one or more TSVs.

9. The amplifier device of claim 8, further comprising:
a second transistor die (220) coupled to the substrate, wherein the second transistor includes a second transistor (224) with a base terminal (226), an emitter terminal, and a collector terminal (230), wherein the base terminal is electrically coupled to the input terminal, the emitter terminal is electrically coupled to the ground reference node, and the collector terminal is electrically coupled to the one or more first source terminals of the first transistor die, and
wherein the first transistor has a common-gate configuration, the second transistor has a common-emitter configuration, and the first and second transistors are electrically coupled together to form a cascode amplifier.

10. The amplifier device of claim 8, further comprising:
a second transistor die (220) coupled to the substrate, wherein the second transistor includes a second transistor (224) with a second gate terminal (226), a second source terminal, and a second drain terminal (230), wherein the second gate terminal is electrically coupled to the input terminal, the second source terminal is electrically coupled to the ground reference node, and the second drain terminal is electrically coupled to the one or more first source terminals of the first transistor die, and
wherein the first transistor has a common-gate configuration, the second transistor has a common-source configuration, and the first and second transistors are electrically coupled together to form a cascode amplifier.

11. The amplifier device of claim 8, further comprising:
a capacitor (292) electrically coupled between the one or more first gate terminals and the ground reference node.

12. The amplifier device of claim 8, wherein each field plate of the multiple transistor fingers is an elongated conductive feature that has a proximal end (267) and a distal end (268), wherein the proximal end of each field plate is coupled to the proximal end of the TSV, and the distal end of each field plate is electrically floating.

13. The amplifier device of claim 8, wherein the first transistor die further comprises:
a conductive layer (248) on the bottom surface of the base substrate, wherein the distal end of each of the one or more TSVs is coupled to the conductive layer.

14. The amplifier device of claim 8, wherein the first transistor die further comprises:
a gate manifold (262) between the one or more gate terminals and the active area, wherein the gate manifold extends along an axis that is parallel with the first side surface of the semiconductor substrate, and wherein the gate of each of the multiple transistor fingers is electrically coupled to the gate manifold.

15. The amplifier device of claim 8, wherein:
the one or more gate terminals are exposed at the top surface of the semiconductor substrate between the active area and the first side surface;
the one or more source terminals are exposed at the top surface of the semiconductor substrate between the active area and the first side surface;
the at least one drain terminal is exposed at the top surface of the semiconductor substrate between the active area and the second side surface; and
the one or more TSVs are located in a gap (286) between the active area and the second side surface.

## Amended claims

### Amended claims in accordance with Rule 137(2) EPC.

1. A transistor die (240) comprising:
a semiconductor substrate that includes a top surface (243), a bottom surface (244), a first side surface (245) extending between the top and bottom surfaces, a second side surface (246) extending between the top and bottom surfaces, a base substrate (241), and a build-up structure (242) integrally formed on the base substrate;
a transistor (247) within an active area in the semiconductor substrate between the first and second side surfaces, wherein the transistor includes multiple transistor fingers, and each transistor finger includes a source region (275), a drain region (285), a channel region (265) between the source region and the drain region, a gate (264) overlying the channel region, a source contact (272) overlying the source region, a drain contact (282) overlying the drain region, and a field plate (266) in the build-up structure between the gate and the drain contact;
one or more gate terminals (260), wherein the gate of each of the multiple transistor fingers is electrically coupled to the one or more gate terminals;
one or more source terminals (270), wherein the source contact of each of the multiple transistor fingers is electrically coupled to the one or more source terminals;
at least one drain terminal (280); and
one or more through-substrate vias (269), TSVs, wherein each TSV of the one or more TSVs extends between a proximal end at a top surface of the base substrate and a distal end at a bottom surface of the base substrate;
a conductive layer (248) on the bottom surface of the base substrate, wherein the distal end of each of the one or more TSVs is coupled to the conductive layer, and
wherein each field plate of the multiple transistor fingers is electrically coupled through the build-up structure to the proximal end of a TSV of the one or more TSVs;
wherein:
the one or more gate terminals are exposed at the top surface of the semiconductor substrate between the active area and the first side surface;
the one or more source terminals are exposed at the top surface of the semiconductor substrate between the active area and the first side surface;
the at least one drain terminal is exposed at the top surface of the semiconductor substrate between the active area and the second side surface; and
the one or more TSVs are located in a gap between the active area and the second side surface.

2. The transistor die of claim 1, wherein:
the one or more gate terminals include multiple gate terminals;
the one or more source terminals include multiple source terminals; and
the multiple gate terminals and the multiple source terminals are arranged in an alternating sequence along an axis that is parallel with the first side surface.

3. The transistor die of any of the preceding claims, wherein each field plate of the multiple transistor fingers is an elongated conductive feature that has a proximal end (267) and a distal end (268), wherein the proximal end of the field plate is coupled to the proximal end of the TSV, and the distal end of the field plate is not coupled to any further circuitry beyond the distal end.

4. The transistor die of claim 2, or claim 3 or 4 when dependent on claim 3, further comprising:
a gate manifold (262) between the multiple gate terminals and the active area, wherein the gate manifold extends along the axis that is parallel with the first side surface of the semiconductor substrate, and wherein the gate of each of the multiple transistor fingers is electrically coupled to the gate manifold.

5. The transistor die of claim 4, further comprising:
source metallization (272) that electrically couples the one or more source terminals to the source region of each of the multiple transistor fingers, wherein the gate manifold extends underneath portions of the source metallization, and the source metallization overlies the gate manifold.

6. An amplifier device (200) comprising:
a substrate (214);
an input terminal (211);
an output terminal (212);
a ground reference node (213, 214); and
a first transistor die (240) coupled to the substrate, wherein the first transistor die includes
a semiconductor substrate that includes a top surface (243), a bottom surface (244), a first side surface (245) extending between the top and bottom surfaces, a second side surface (246) extending between the top and bottom surfaces, a base substrate (241), and a build-up structure (242) integrally formed on the base substrate,
a first transistor (247) within an active area in the semiconductor substrate between the first and second side surfaces, wherein the first transistor includes multiple transistor fingers, and each transistor finger includes a source region (275), a drain region (285), a channel region (265) between the source region and the drain region, a gate (264) overlying the channel region, a source contact (272) overlying the source region, a drain contact (282) overlying the drain region, and a field plate (266) in the build-up structure between the gate and the drain contact,
one or more first gate terminals (260), wherein the gate of each of the multiple transistor fingers is electrically coupled to the one or more first gate terminals,
one or more first source terminals (270), wherein the source contact of each of the multiple transistor fingers is electrically coupled to the one or more first source terminals,
at least one first drain terminal (280), wherein the at least one first drain terminal is electrically coupled to the output terminal;
a conductive layer (248) on the bottom surface of the base substrate, wherein the distal end of each of the one or more TSVs is coupled to the conductive layer, and
one or more through-substrate vias (269), TSVs, wherein each TSV of the one or more TSVs extends between a proximal end at a top surface of the base substrate and a distal end at a bottom surface of the base substrate, and
wherein each field plate of the multiple transistor fingers is electrically coupled through the build-up structure to the proximal end of a TSV of the one or more TSVs;
wherein each field plate of the multiple transistor fingers is an elongated conductive feature that has a proximal end (267) and a distal end (268), wherein the proximal end of each field plate is coupled to the proximal end of the TSV, and the distal end of each field plate is not coupled to any further circuitry beyond the distal end.

7. The amplifier device of claim 6, further comprising:
a second transistor die (220) coupled to the substrate, wherein the second transistor die includes a second transistor (224) with a base terminal (226), an emitter terminal, and a collector terminal (230), wherein the base terminal is electrically coupled to the input terminal, the emitter terminal is electrically coupled to the ground reference node, and the collector terminal is electrically coupled to the one or more first source terminals of the first transistor die, and
wherein the first transistor has a common-gate configuration, the second transistor has a common-emitter configuration, and the first and second transistors are electrically coupled together to form a cascode amplifier.

8. The amplifier device of claim 6, further comprising:
a second transistor die (220) coupled to the substrate, wherein the second transistor die includes a second transistor (224) with a second gate terminal (226), a second source terminal, and a second drain terminal (230), wherein the second gate terminal is electrically coupled to the input terminal, the second source terminal is electrically coupled to the ground reference node, and the second drain terminal is electrically coupled to the one or more first source terminals of the first transistor die, and
wherein the first transistor has a common-gate configuration, the second transistor has a common-source configuration, and the first and second transistors are electrically coupled together to form a cascode amplifier.

9. The amplifier device of claim 6, further comprising:
a capacitor (292) electrically coupled between the one or more first gate terminals and the ground reference node.

10. The amplifier device of claim 6, wherein the first transistor die further comprises:
a gate manifold (262) between the one or more first gate terminals and the active area, wherein the gate manifold extends along an axis that is parallel with the first side surface of the semiconductor substrate, and wherein the gate of each of the multiple transistor fingers is electrically coupled to the gate manifold.

11. The amplifier device of claim 6, wherein:
the one or more first gate terminals are exposed at the top surface of the semiconductor substrate between the active area and the first side surface;
the one or more first source terminals are exposed at the top surface of the semiconductor substrate between the active area and the first side surface;
the at least one first drain terminal is exposed at the top surface of the semiconductor substrate between the active area and the second side surface; and
the one or more TSVs are located in a gap (286) between the active area and the second side surface.
